# EUROPÄISCHE PATENTSCHRIFT

(11) **EP 1 155 287 B1**
(45) Veröffentlichungstag und Bekanntmachung des Hinweises auf die Patenterteilung: **11.09.2002**
(21) Anmeldenummer: 00904921.4
(22) Anmeldetag: 17.01.2000
(51) Int. Cl.: G01D 3/02, G01D 5/14, H01L 43/04, H01L 43/06

(54) **HALL-SENSOR MIT REDUZIERTEM OFFSET-SIGNAL**
HALL SENSOR WITH A REDUCED OFFSET SIGNAL
CAPTEUR DE HALL A SIGNAL DE DECALAGE REDUIT

(30) Priorität: 26.02.1999 DE 19908473
(43) Veröffentlichungstag der Anmeldung: 21.11.2001
(73) Patentinhaber: FRAUNHOFER-GESELLSCHAFT ZUR FÖRDERUNG DER ANGEWANDTEN FORSCHUNG E.V., 80636 München (DE)
(72) Erfinder: HOHE, Hans-Peter, D-91332 Heiligenstadt (DE); WEBER, Norbert, D-91367 Wei enohe (DE); SAUERER, Josef, D-91074 Herzogenaurach (DE)
(74) Vertreter: Schoppe, Fritz, Dipl.-Ing.
(86) Internationale Anmeldenummer: EP0000313
(87) Internationale Veröffentlichungsnummer: WO00052424

(56) Entgegenhaltungen:
- US-A- 5 614 754
- PATENT ABSTRACTS OF JAPAN vol. 008, no. 256 (E-280), 22. November 1984 (1984-11-22) & JP 59 129483 A (MATSUSHITA DENKI SANGYO KK), 25. Juli 1984 (1984-07-25)
- PATENT ABSTRACTS OF JAPAN vol. 007, no. 123 (E-178), 27. Mai 1983 (1983-05-27) & JP 58 042282 A (DAINI SEIKOSHA KK), 11. März 1983 (1983-03-11)
- PATENT ABSTRACTS OF JAPAN vol. 006, no. 226 (E-141), 11. November 1982 (1982-11-11) & JP 57 128086 A (TOKYO SHIBAURA DENKI KK), 9. August 1982 (1982-08-09)
- PATENT ABSTRACTS OF JAPAN vol. 012, no. 293 (E-645), 10. August 1988 (1988-08-10) & JP 63 070583 A (ASAHI GLASS CO LTD), 30. März 1988 (1988-03-30)

## Beschreibung

Die vorliegende Erfindung bezieht sich auf Hall-Sensoren und insbesondere auf in einer CMOS-Technologie implementierte Hall-Sensoren mit einer verbesserten Kontaktelektrodengeometrie zur Verringerung des Offset-Signals.

Ein Hall-Sensor ist im allgemeinen aus einem n-dotierten aktiven Halbleiterbereich auf einem p-dotierten Halbleitersubstrat aufgebaut. Der n-dotierte aktive Bereich ist üblicherweise über vier Kontaktelektroden, die diagonal gegenüberliegend in dem aktiven Bereich angeordnet sind, mit einer externen Ansteuerlogik verbunden. Die vier Kontaktelektroden unterteilen sich in zwei gegenüberliegende Steuerstromkontaktelektroden, die vorgesehen sind, um einen Stromfluß durch den aktiven Bereich zu erzeugen, und ferner in zwei gegenüberliegende Spannungsabgriffkontaktelektroden, die vorgesehen sind, um eine Hall-Spannung, die bei einem anliegenden Magnetfeld senkrecht zu dem Stromfluß in dem aktiven Bereich auftritt, als Sensorsignal abzugreifen.

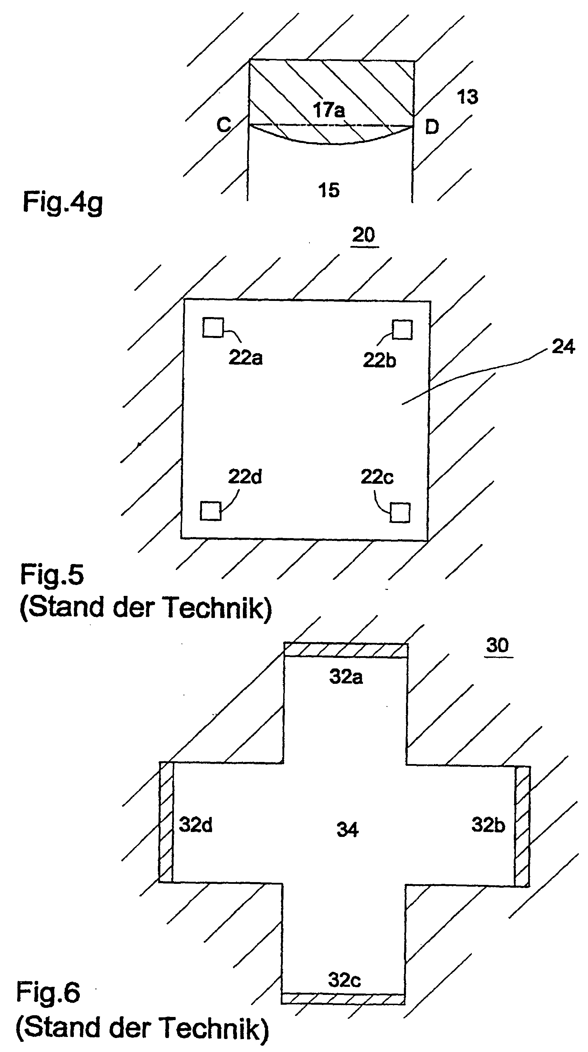

Bei Hall-Sensoren mit der oben beschriebenen Anordnung sind im wesentlichen zwei Geometrien für den aktiven Sensorbereich bekannt, die in Fig. 5 und 6 dargestellt sind. Fig. 5 zeigt einen quadratischen Hall-Sensor 20, dessen Kontaktelektroden 22a-d jeweils in den Ecken des aktiven Bereichs 24 angeordnet sind. Die Form der Kontaktelektroden 22a-d dieser bekannten Hall-Sensoranordnung ist üblicherweise quadratisch. Während des Betriebs des Hall-Sensors 20 wird zwischen zwei diagonal gegenüberliegenden Kontaktelektroden 22a, 22c ein Strom eingespeist, um bei einem anliegenden Magnetfeld eine Hall-Spannung über die anderen beiden Kontaktelektroden 22b, 22d abgreifen zu können.

Fig. 6 zeigt eine kreuzförmige Hall-Sensoranordnung 30, in der Form eines "griechisches Kreuzes", bei der die rechteckigen Kontaktelektroden 32a-d jeweils am Ende eines Kreuzarms liegen, wobei die rückseitige Begrenzung der Kontaktelektroden 32a-d mit der Begrenzung des aktiven Bereichs 34 identisch ist. Die Breite der Kontaktelektroden 32a-d entspricht dabei der Breite des Kreuzarms, d.h. die Kontaktelektroden 32a-d erstrecken sich in dem jeweiligen Kreuzarm über die gesamte Breite des aktiven Bereichs 34. Analog zu dem quadratischen Hall-Sensor wird während des Betriebs des kreuzförmigen Hall-Sensors zwischen zwei gegenüberliegenden Kontaktelektroden 32a, 32c ein Strom eingespeist, um bei einem anliegenden Magnetfeld eine Hall-Spannung über die anderen beiden Kontaktelektroden 32b, 32d abgreifen zu können.

Bei CMOS-Prozessen zur Herstellung von Halbleiterstrukturen treten jedoch produktionsbedingt häufig Inhomogenitäten oder Störungen in dem Halbleitermaterial des aktiven Bereichs auf. Diese Inhomogenitäten lassen sich auch mit aufwendigen Herstellungsverfahren nicht vollständig vermeiden. Diese Inhomogenitäten sind jedoch häufig ein Grund für das Auftreten eines Offsets des Sensorsignals. Das heißt, an den Kontaktelektroden, an denen die Hall-Spannung abgegriffen wird, wird auch dann ein Sensorsignal erfaßt, wenn kein Magnetfeld an dem aktiven Bereich anliegt. Dieses störende Sensorsignal wird als der Offset des Sensornutzsignals oder einfach auch als Offset-Signal bezeichnet. Wenn sich diese Inhomogenitäten an ungünstigen Positionen in dem aktiven Bereich befinden, kann es bei den bekannten Hall-Sensorelementen zu einem relativ hohen Offset-Signal kommen, da sich die Stromlinien in dem aktiven Bereich ungünstig verschieben können und sich dadurch ein lokal hoher Widerstand in dem aktiven Bereich ergibt. Dabei ist der an dem Hall-Sensorelement auftretende Offset des Sensorsignals sowohl von der Anzahl der Inhomogenitäten als auch von der Position der Inhomogenitäten stark abhängig.

Durch diese starke Abhängigkeit des Offset-Signals von den Inhomogenitäten treten bei herkömmlichen Hall-Sensorelementen große Exemplarstreuungen auf. Ferner wird die Empfindlichkeit und die Meßgenauigkeit der Hall-Sensoren stark beeinträchtigt. Aus diesem Grund ist eine Offset-Kompensation und eine korrekte Auswertung der Sensorsignale im allgemeinen mit einem großen schaltungstechnischen Aufwand verbunden.

Die JP 59129483 A betrifft ein Hall-Element, das hergestellt wird, indem auf der Oberfläche eines semi-isolierenden Substrats ein quadratischer Dünnfilm mit einem festen Leitungstyp gebildet wird, und indem an den vier Ecken des Dünnfilms ohmsche Elektroden eingerichtet werden.

Die JP 58042282 A betrifft ein Hall-Element mit jeweils zwei festgelegten Hall-Spannungsabgriffselektroden und zwei festgelegten Stromeingangselektroden. Die zwei einander gegenüberliegenden Stromeingangselektroden des Hall-Elements sind derart ausgestaltet, daß sich deren Mittelabschnitte näher aneinander befinden als deren Endabschnitte. Die Stromeingangselektroden erstrecken sich jeweils über die gesamte Breite zweier gegenüberliegender Seiten des aktiven Bereichs des Hall-Elements. Die Spannungsabgriffselektroden sind jeweils in der Mitte der beiden anderen Seitenabschnitte des aktiven Bereichs angeordnet. Durch diese Kontaktelektrodenanordnung soll unter anderem der Kurzschlußeffekt zwischen den Stromeingangselektroden 1, 2 und den Hall-Ausgangselektroden reduziert werden.

Die JP3-211778A beschreibt ein Hall-Element, das eine im wesentlichen quadratische aktive Schicht aufweist, die an ihren vier Ecken Elektroden besitzt. Ein erstes Elektrodenpaar ist an gegenüberliegenden Ecken paarweise angeordnet, um ein Eingangssignal einzuspeisen, während ein zweites Elektrodenpaar an den anderen beiden gegenüberliegenden Ecken paarweise angeordnet ist, um das Ausgangssignal, d.h. die Hall-Spannung, abzugreifen. Die Kontaktelektroden sind in der Form eines rechtwinkligen Dreiecks ausgeführt, wobei die Elektroden jeweils schlüssig an den jeweiligen Randbereichen der aktiven Schicht anliegen.

Ausgehend von diesem Stand der Technik besteht die Aufgabe der vorliegenden Erfindung darin, ein verbessertes Hall-Sensorelement mit einem reduzierten Offset in dem Sensorsignal zu schaffen.

Diese Aufgabe wird durch ein Hall-Sensorelement gemäß Anspruch 1 gelöst.

Die vorliegende Erfindung schafft ein Hall-Sensorelement mit einem aktiven Bereich und Kontaktelektroden, die Kontaktelektroden aus zwei gegenüberliegenden Stromversorgungskontaktelektroden, zwischen denen der aktive Bereich definiert ist, zum Erzeugen eines Stromflusses durch den aktiven Bereich, und aus zwei gegenüberliegenden Spannungsabgriffskontaktelektroden zum Abgreifen einer Hall-Spannung gebildet sind. Das Hall-Sensorelement ist dadurch gekennzeichent, daß ein Abschnitt der Kontaktelektroden, der dem aktiven Bereich zugewandt ist und an den aktiven Bereich angrenzt, eine Geometrie aufweist, die stufenförmig, kreissegmentförmig, elliptisch, parabelförmig, hyperbelförmig oder trapezförmig ist oder eine rechteckige Erhöhung aufweist, um den störenden Einfluß der Kontaktelektroden auf die Offset-reduzierende Wirkung des Spinning-Current-Betriebs zu reduzieren, wobei alle Kontaktelektroden eine identische Geometrie aufweisen und jeweils symmetrisch bezüglich des aktiven Bereichs angeordnet sind, und wobei die Seitenlänge der Kontaktelektroden maximal 20% der Seitenlänge des aktiven Bereichs beträgt.

Der vorliegenden Erfindung liegt die Erkenntnis zugrunde, daß der in einem Hall-Sensorelement auftretende Offset des Sensorsignals durch die geeignete Wahl der Geometrie der verwendeten Kontaktelektroden stark verringert werden kann. Entscheidend für einen kleinen Offset des Sensorsignals ist nämlich nicht nur eine homogene Stromdichteverteilung des Steuerstroms bei idealen Verhältnissen im Halbleitermaterial, d.h. ohne Inhomogenitäten, aus der sich im wesentlichen die herkömmlichen Sensorstrukturen ergeben, sondern vielmehr ist es von erheblich größerer Bedeutung, wie sich die Stromdichteverteilung durch vorhandene Inhomogenitäten oder Störungen in dem Halbleitermaterial des aktiven Bereichs und insbesondere an den Kontakten ändert. Gleichzeitig sollte der resultierende Offset des Sensorsignals möglichst unabhängig von der Position der Inhomogenitäten oder Störungen in dem Halbleitermaterial sein, um die Streuung der resultierenden Offsetwerte gering zu halten.

Die Vorteile der erfindungsgemäßen Geometrien beruhen auf den folgenden Zusammenhängen. Der an einem Hallelement von außen meßbare Offset hängt von drei wesentlichen Faktoren ab:
- der Stärke und Ausdehnung des Effekts im Element;
- der Betriebsspannung am Element;
- der Geometrie des Elements.

Die ersten beiden Faktoren sollen in diesem Zusammenhang nicht weiter beachtet werden. Es bleibt in diesem Fall nur die Geometrie für Veränderungen übrig. Die Geometrie hat weitreichenden und vielfältigen Einfluß auf die Eigenschaften des Elements. Eine besondere Verbindung besteht zwischen der Kontaktgeometrie und dem mittels des nachfolgend erläuterten Spinning-Currents reduzierten Offset des Elements.

Das Spinning-Current-Verfahren besteht darin, daß die Meßrichtung ständig mit einer bestimmten Taktfrequenz um beispielsweise 90° zyklisch weitergedreht wird, d.h. der Betriebsstrom fließt von einer zu der gegenüberliegenden Kontaktelektrode, wobei die Hall-Spannung an den quer dazu liegenden Kontaktelektroden abgegriffen wird, woraufhin dann beim nächsten Zyklus die Meßrichtung um 90° weitergedreht wird. Die gemessenen Hall-Spannungen werden summiert, wobei sich die Offset-Spannungen bei einem Umlauf annähernd gegenseitig aufheben sollten, so daß die echt magnetfeldabhängigen Anteile des Signals übrig bleiben.

Bereits beim Betrieb ohne Spinning-Current ergeben sich abhängig von der gewählten Element- und Kontakt-Geometrie Positionen, an denen Effekte nicht stören und Positionen, an denen sie einen großen Offset hervorrufen. Ein gutes Beispiel ist hier die Verbindungslinie zwischen den beiden Steuerstromkontakten. Defekte auf dieser Verbindungslinie führen aus Symmetriegründen nicht zu einem Offset. Sobald man aber etwas von dieser Linie abweicht, ergibt sich sofort ein meßbarer Offset an den Hallkontakten, obwohl die Stromdichte an beiden Punkten nahezu identisch und nicht verschwindend klein ist.

Beim Betrieb mit Spinning-Current ergibt sich, abhängig von der Geometrie, auch eine solche Sensitivitätsfunktion über dem Ort, die die Auswirkung eines Defekts an einer bestimmten Stelle auf den Offset beschreibt. Diese Funktion sieht im Falle endlich ausgedehnter Steuer- bzw. Hall-Kontakte relativ kompliziert aus. Sie besitzt bei einem normalen Hallkreuz Nullstellen auf den Verbindungslinien zwischen jeweils gegenüberliegenden Kontakten und zusätzlich den Winkelhalbierenden des Innenbereichs des Kreuzes. Der restliche Verlauf und damit insbesondere die Extrema dieser Funktion im aktiven Bereich können durch geeignete Wahl der Element- und Kontakt-Geometrie beeinflußt werden. In der Regel befinden sich an den Kanten des Elements und der Kontakte die Orte mit hoher Relevanz für den Offset, während die Innenbereiche in der Regel keine neuen lokalen Extremwerte besitzen. Da sich durch Modifikationen an der Geometrie auch alle anderen Eigenschaften des Elements ändern können, müssen bei Änderungen an den Kontakten auch alle anderen Eigenschaften beachtet werden.

Bei den erfindungsgemäßen Kontakten wurde deren Geometrie so gestaltet, daß ein niedriger Offset mit hoher Ausbeute und nahezu unveränderter Empfindlichkeit erreicht werden kann.

Die nutzbare Auflösung erhöht sich damit entsprechend dem niedrigeren Offset des Elements.

Bevorzugte Ausführungsbeispiele der vorliegenden Erfindung werden nachfolgend unter Bezugnahme auf die beiliegenden Zeichnungen näher beschrieben. Es zeigen:
- Fig. 1: eine prinzipielle Darstellung eines quadratischen Hall-Sensorelements mit erfindungsgemäßen Kontaktelektroden;
- Fig. 2a-e: prinzipielle Darstellungen der unterschiedlichen Strukturen der erfindungsgemäßen Kontaktelektroden für ein quadratisches Hall-Sensorelement;
- Fig. 3a: eine prinzipielle Darstellung eines kreuzförmigen Hall-Sensorelements mit erfindungsgemäßen Kontaktelektroden und Fig. 3b-d modifizierte Formen der Kreuzstruktur;
- Fig. 4a-g: prinzipielle Darstellungen der unterschiedlichen Strukturen der erfindungsgemäßen Kontaktelektroden für ein kreuzförmiges Hall-Sensorelement;
- Fig. 5: ein bekanntes Hall-Sensorelement mit einem quadratischen aktiven Bereich und herkömmlichen Kontaktelektroden; und
- Fig. 6: ein bekanntes Hall-Sensorelement mit einem kreuzförmigen aktiven Bereich und herkömmlichen Kontaktelektroden.

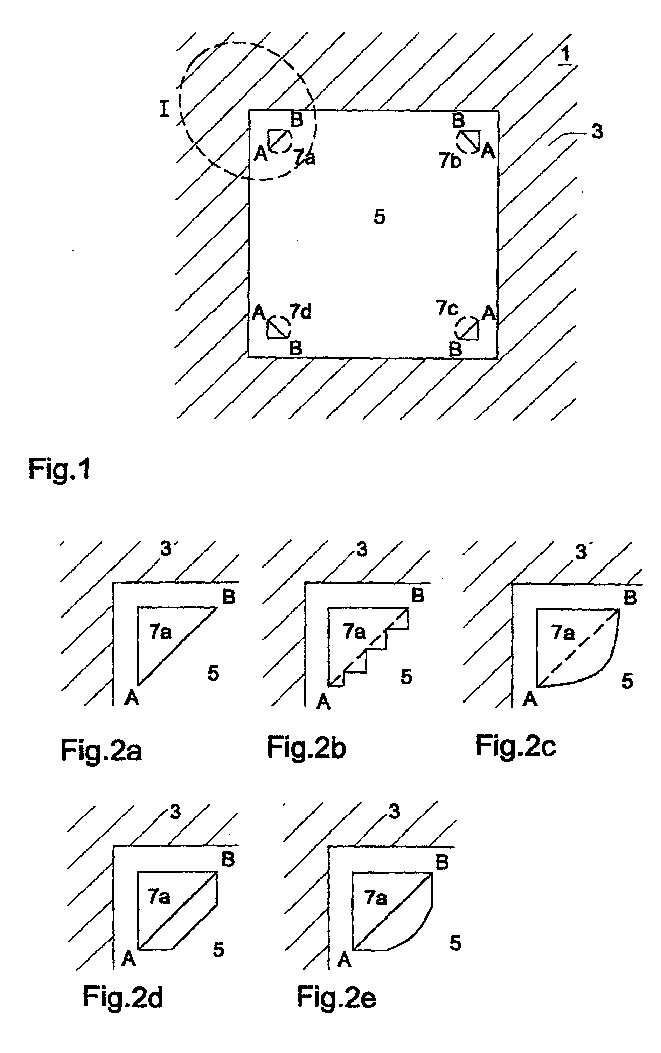

Bezugnehmend auf Fig. 1 ist der allgemeine Aufbau eines rechteckigen Hall-Sensorelements 1 dargestellt. Auf einem Halbleitersubstrat 3, das vorzugsweise p-dotiert ist, ist ein rechteckiger aktiver Halbleiterbereich 5 aufgebracht, der im allgemeinen n-dotiert ist. In unmittelbarer Nähe der Ecken des n-dotierten aktiven Bereichs 5 sind Kontaktelektroden 7a-d angeordnet, die im allgemeinen durch eine n⁺-Dotierung erhalten werden. Die Kontaktelektroden 7a-d sind in dem n-dotierten aktiven Bereich 5, der von dem p-dotierten Substrat umgeben ist, jeweils diagonal gegenüberliegend angeordnet. Der gestrichelt dargestellte Verlauf der dem aktiven Bereich 5 zugewandten Abschnitte der Kontaktelektroden 7a-d soll weitere unterschiedliche neue Strukturen der Kontaktelektroden 7a-d andeuten, die im folgenden bezugnehmend auf die Fig. 2a-f einzeln detailliert beschrieben werden.

In den Fig. 2a-e sind die unterschiedlichen bevorzugten Geometrien der Kontaktelektroden 7a-d dargestellt. Zur Vereinfachung der folgenden Beschreibung ist jeweils nur ein maßstäblich vergrößerter Eckbereich des Hall-Sensorelements 1 mit der darin angeordneten Kontaktstruktur 7a dargestellt (siehe den gestrichelt eingekreisten Ausschnitt I in Fig. 1), da die anderen Kontaktelektroden 7b-d im allgemeinen eine identische Struktur aufweisen und symmetrisch in den anderen Ecken des aktiven Bereichs 5 angeordnet sind. Zur Erleichterung der Beschreibung werden die in Fig. 2a-e dargestellten Kontaktelektroden 7a-d formal in zwei Abschnitte unterteilt, d.h. in einen dem aktiven Bereich 5 zugewandten Abschnitt und in einen dem aktiven Bereich 5 abgewandten Abschnitt. Ferner werden zwei Endpunkte A und B an den Kontaktelektroden 7a-d definiert, zwischen denen die erfindungsgemäßen Strukturen der Kontaktelektroden 7a-d verlaufen.

Bei dem Ausführungsbeispiel von Fig. 2a ist der dem aktiven Bereich 5 zugewandte Abschnitt der Kontaktelektrode 7a als gerade Linie ausgebildet, so daß die Kontaktelektrode 7a in der Form eines gleichschenkligen Dreiecks ausgebildet ist.

Fig. 2b zeigt eine Ausführungsform für die Struktur der Kontaktelektrode 7a, bei der die Endpunkte A, B des dem aktiven Bereich zugewandten Abschnitts der Kontaktelektrode 7a treppen- oder stufenförmig verbunden sind, so daß sich die in Fig. 2b dargestellte treppen- oder stufenförmige Verlauf der Kontaktelektrodengeometrie ergibt.

Fig. 2c zeigt eine Kontaktelektrodengeometrie, die zwischen den Endpunkten A, B eine kreissegmentförmige Struktur aufweist, die zum aktiven Bereich hin gewölbt ist. Diese gewölbte Struktur der Kontaktelektrode kann ferner einen elliptischen, parabelförmigen oder hyperbelförmigen Verlauf annehmen.

In Fig. 2d ist eine Kontaktelektrodengeometrie dargestellt, bei der der dem aktiven Bereich zugewandte Abschnitt der Kontaktelektrode 7a die Form eines gleichschenkligen Trapez aufweist, wobei die längere Grundlinie des Trapez zwischen den Endpunkten A und B der Kontaktelektrodengeometrie verläuft.

In Fig. 2e ist eine Struktur der Kontaktelektrode 7a dargestellt, die gegenüber der in Fig. 2d gezeigten Struktur dahingehend weitergebildet ist, daß die kürzere, dem aktiven Bereich 5 zugewandte Grundlinie des Trapez einen kreissegmentförmigen, elliptischen, parabelförmigen oder hyperbelförmigen Verlauf aufweist, der in Richtung des aktiven Bereichs gewölbt ist.

Die im vorhergehenden beschriebenen Kontaktelektrodengeometrien können für eine exakte mathematische Beschreibung auch durch einen Polygonzug angenähert werden.

Es hat sich außerdem herausgestellt, daß die Seitenlänge der Kontaktelektroden maximal 20% der Seitenlänge des aktiven Bereichs betragen sollte, um optimale Betriebseigenschaften des Hall-Sensors mit einem wesentlich reduzierten Offset-Signal zu erhalten, d.h. damit die Stromdichteverteilung in dem aktiven Bereich eines Hall-Sensors von der Position von Inhomogenitäten oder Störungen in dem Halbleitermaterial im wesentlichen unabhängig ist.

Ferner sollte beachtet werden, daß die Struktur des dem aktiven Bereich abgewandten Abschnitts der Kontaktelektroden 7a-d nicht nur, wie es in den Fig. 2a-f dargestellt ist, auf einen dreieckigen Verlauf beschränkt ist, sondern eine für den jeweiligen Anwendungsfall zweckmäßige Form beispielsweise zur Kontaktierung nach Außen oder zur Herausführung der Kontaktelektroden aufweisen kann. Der Verlauf des dem aktiven Bereich abgewandten Abschnitts der Kontaktelektroden 7a-d ist jedoch für den Gegenstand der vorliegenden Erfindung nicht wesentlich.

Mittels der im vorhergehenden beschriebenen, neuen Strukturen für die Kontaktelektroden eines Hall-Sensorelements lassen sich die ungünstigen Offset-Signale, die beispielsweise aufgrund von herstellungsbedingten Inhomogenitäten in dem Halbleitermaterial des aktiven Bereichs auftreten und die das Hall-Spannungssignal überlagern, reduzieren. Diese Verbesserung wird mittels der erfindungsgemäßen Kontaktelektrodenstrukturen dadurch erreicht, daß das resultierende Offset-Signal von der Position der Inhomogenitäten oder Störungen des Halbleitermaterials des aktiven Bereichs im wesentlichen unabhängig ist. Dadurch lassen sich Exemplarstreuungen verringern und die Meßgenauigkeit der Hall-Sensorelemente, die die oben beschriebenen neuartigen Kontaktstrukturen verwenden, verbessern.

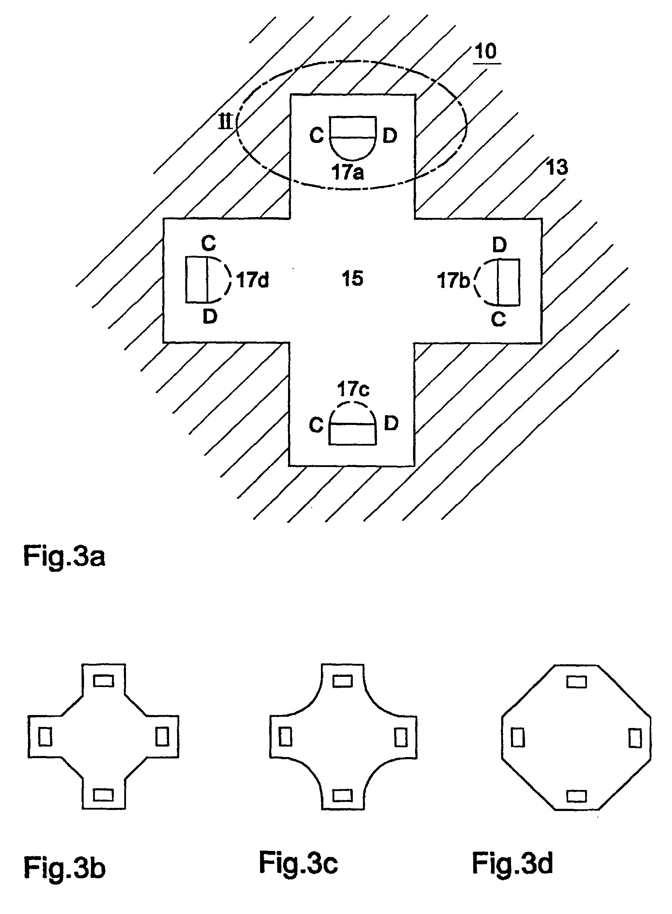

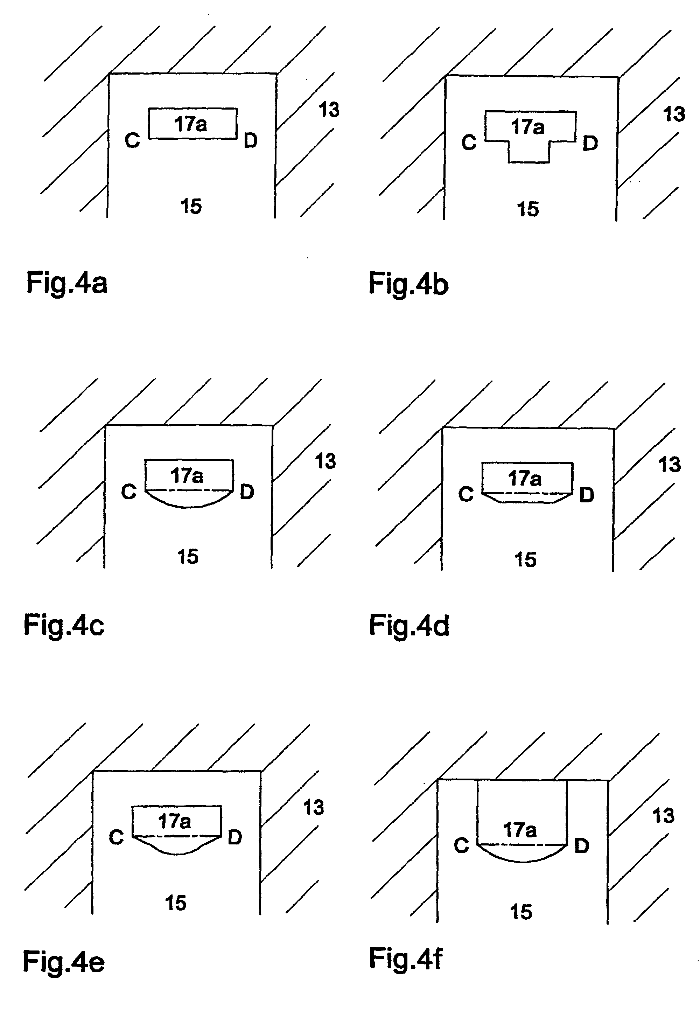

Bezugnehmend auf Fig. 3a ist der allgemeine Aufbau eines kreuzförmigen Hall-Sensorelements 10 dargestellt. Auf einem Halbleitersubstrat 13, das vorzugsweise p-dotiert ist, ist ein kreuzförmiger aktiver Halbleiterbereich 15 aufgebracht, der im allgemeinen n-dotiert ist. In der Nähe der Enden der Kreuzarme des aktiven Bereichs 15 sind Kontaktelektroden 17a-d angeordnet, die im allgemeinen durch eine n⁺-Dotierung erhalten werden. Die jeweiligen Kontaktelektroden 17a-d, die zum Erzeugen eines Stromflusses durch das Hall-Sensorelement bzw. zum Abgreifen einer bei einem anliegenden Magnetfeld auftretenden Hall-Spannung vorgesehen sind, sind in den Kreuzarmen jeweils symmetrisch gegenüberliegend angeordnet. Der gestrichelt dargestellte Verlauf der dem aktiven Bereich zugewandten Abschnitte der Kontaktelektroden soll entsprechend zu Fig. 1 weitere unterschiedliche neue Strukturen der Kontaktelektroden 17a-d andeuten, die im folgenden bezugnehmend auf die Fig. 4a-g einzeln detailliert beschrieben werden.

Natürlich können auch modifizierte Kreuzelemente verwendet werden, bei denen die nach innen ragenden Ecken des Elements entsprechend den Beispielen, die in den Fig. 3b-d gezeigt sind, verändert sind. Dabei kann Fig. 3d als ein Grenzfall zu einem quadratischen Element betrachtet werden.

In den Fig. 4a-g sind die unterschiedlichen bevorzugten Geometrien der Kontaktelektroden 17a-d dargestellt. Zur Vereinfachung der folgenden Beschreibung ist in den Fig. 4a-g jeweils nur ein Kreuzarm des Hall-Sensorelements 10 mit der darin angeordneten Kontaktstruktur 17a dargestellt (siehe den gestrichelt eingekreisten Ausschnitt II in Fig. 3a), da die anderen Kontaktelektroden 17b-d eine identische Struktur aufweisen und symmetrisch in den anderen Kreuzarmen des aktiven Bereichs 15 angeordnet sind. Zur Vereinfachung der Beschreibung werden die in Fig. 4a-g dargestellten Kontaktelektroden formal in zwei Abschnitte unterteilt, d.h. in einen dem aktiven Bereich zugewandten Abschnitt und in einen dem aktiven Bereich abgewandten Abschnitt. Ferner werden wieder zwei Endpunkte C und D definiert, zwischen denen die erfindungsgemäßen Strukturen der Kontaktelektroden 17a-d verlaufen.

Im einfachsten Fall, der in Fig. 4a dargestellt ist, weist die Geometrie der Kontaktelektrode 17a einen rechteckigen Verlauf auf, wobei die Kontaktelektrode 17a vollständig von n-dotiertem Material umgeben ist.

In Fig. 4b ist ein weiterer möglicher Verlauf für den dem aktiven Bereich 15 zugewandten Abschnitt der Kontaktelektrode 17a dargestellt. Dieser Verlauf ist als rechteckige Erhöhung zwischen den Endpunkten C, D ausgebildet.

Fig. 4c zeigt eine Kontaktelektrodengeometrie, bei der die Kontaktelektrode 17a zwischen den Endpunkten C, D einen kreissegmentförmigen Verlauf aufweist, der zu dem aktiven Bereich hin gewölbt ist. Der Verlauf kann ferner elliptisch, parabelförmig oder hyperbelförmig sein.

Die Geometrie des dem aktiven Bereich zugewandten Abschnitts der Kontaktelektrode 17a kann ferner, wie es in Fig. 4d dargestellt, einen trapezförmigen Verlauf annehmen, wobei die längere Grundlinie des Trapez mit einer gedachten Verbindungslinie zwischen den Endpunkten C und D zusammenfällt.

In Fig. 4e ist eine Struktur der Kontaktelektrode 17a dargestellt, die gegenüber der in Fig. 4d gezeigten Struktur dahingehend weitergebildet ist, daß die kürzere Grundlinie des Trapez einen kreissegmentförmigen, elliptischen, parabelförmigen oder hyperbelförmigen Verlauf, der in Richtung des aktiven Bereichs gewölbt ist.

Weitere Ausgestaltungen der Geometrien der Kontaktelektroden, wie sie in den Fig. 4a-g dargestellt sind, können darin bestehen, daß der dem aktiven Bereich abgewandte Abschnitt der Kontaktelektrode zumindest teilweise bis zu dem p-dotierten Substratbereich reicht. Eine Ausführungsform einer solchen Struktur ist beispielhaft in Fig. 4f dargestellt. Der bei diesem Beispiel zwischen den Endpunkten C und D dargestellte kreissegmentförmige Verlauf der Kontaktstruktur 17a kann jedoch auch alle anderen in den Fig. 4a-e dargestellten Kontaktelektrodenverläufe aufweisen.

Ferner kann, wie es in Fig. 4g dargestellt ist, der gesamte dem aktiven Bereich abgewandte Abschnitt der Kontaktelektrode an das p-Substrat anschließend angeordnet sein, wobei die Breite der Kontaktelektrode mit der Breite des aktiven Bereichs im Kreuzarm übereinstimmt, d.h. die Kontaktelektrode 17a erstreckt sich über die gesamte Breite des Kreuzarms. Der dem aktiven Bereich zugewandte Abschnitt der Kontaktelektrode 17a kann dabei die anhand von Fig. 4b-e dargestellten, zu dem aktiven Bereich 15 gewölbten Verläufe aufweisen.

Es sollte außerdem beachtet werden, daß sich die oben beschriebenen Kontaktelektrodenstrukturen nicht nur bei Hall-Sensorelementen einsetzen lassen, deren aktive Bereiche eine kreuzförmige Gestalt aufweisen, sondern diese Strukturen können auch bei Hall-Sensorelementen angewendet werden, deren aktive Bereiche einen sternförmigen Verlauf aufweisen.

Hinsichtlich der Kontaktstrukturen, die sowohl anhand von Fig. 2a-e bezüglich rechteckiger aktiver Bereiche beschrieben wurden, als auch der Kontaktstrukturen, die anhand von Fig. 4a-g bezüglich kreuzförmiger aktiver Bereiche beschrieben wurden, sollte ferner beachtet werden, daß dieselben einerseits vollständig im n-dotierten Bereich liegen können und nur über eine Metallisierungsebene nach außen verbunden sind. Die Kontaktbereiche sind also vollständig von n-dotiertem Halbleiterbereich umgeben. Darüberhinaus besteht die Möglichkeit, daß die Kontaktelektroden nicht vollständig im aktiven Halbleiterbereich liegen, wie es beispielsweise in den Fig. 4 a-g dargestellt ist. Das heißt, daß zumindest ein Rand des dem aktiven Bereich abgewandten Abschnitts der Kontaktelektroden an dem Rand des aktiven Bereichs anliegen kann.

Ferner ist zu beachten, daß die Kontaktelektroden zur Stromversorgung (7a, 7c; 17a, 17c) und die Kontaktelektroden zum Spannungsabgriff (7b, 7d; 17b, 17d) eine identische Struktur aufweisen, was den vorteilhaften Einsatz beim sogenannten "Spinning-Current"-Verfahren zur Offset-Kompensation ermöglicht. Die Vorteile der erfindungsgemäß gestalteten Kontakte kommen insbesondere beim Spinning-Current-Verfahren zum Tragen.

Bei Hall-Sensoren mit den herkömmlichen Kontaktelektrodenstrukturen werden die Offset-Spannungen, die aufgrund von Inhomogenitäten im Halbleitermaterial auftreten, bei jeder unterschiedlichen Stromflußrichtung durch den aktiven Bereich unterschiedliche Werte aufweisen, so daß selbst unter Verwendung des oben beschriebenen Kompensationsverfahrens keine zufriedenstellende Offset-Unterdrückung erreicht werden kann.

Im Gegensatz dazu wird bei einer Verwendung der erfindungsgemäßen Kontaktelektrodenstrukturen eine im wesentlichen vollständige Offset-Kompensation zu erwarten sein, da die Offset-reduzierende Wirkung des Spinning-Current-Betriebs durch die erfindungsgemäßen Kontakte weit weniger stark gestört wird als bei den üblichen Kontaktgeometrien.

## Patentansprüche

1. Hall-Sensorelement (1; 10) mit einem aktiven Bereich (5; 15) und Kontaktelektroden (7a-7d; 17a-17d), wobei die Kontaktelektroden (7a-7d; 17a-17d) aus zwei gegenüberliegenden Stromversorgungskontaktelektroden (7a, 7c; 17a, 17c), zwischen denen der aktive Bereich (5; 15) definiert ist, zum Erzeugen eines Stromflusses durch den aktiven Bereich (5, 15), und aus zwei gegenüberliegenden Spannungsabgriffskontaktelektroden (7b, 7d; 17b, 17d) zum Abgreifen einer Hall-Spannung gebildet sind,
**dadurch gekennzeichent, daß**
ein Abschnitt der Kontaktelektroden (7a-7d; 17a-17d), der dem aktiven Bereich (5, 15) zugewandt ist und an den aktiven Bereich (5, 15) angrenzt, eine Geometrie aufweist, die stufenförmig, kreissegmentförmig, elliptisch, parabelförmig, hyperbelförmig oder trapezförmig ist oder eine rechteckige Erhöhung aufweist, um den störenden Einfluß der Kontaktelektroden (7a-7d; 17a-17d) auf die Offset-reduzierende Wirkung des Spinning-Current-Betriebs zu reduzieren, wobei alle Kontaktelektroden (7a-7d; 17a-17d) eine identische Geometrie aufweisen und jeweils symmetrisch bezüglich des aktiven Bereichs (5; 15) angeordnet sind, und wobei die Seitenlänge der Kontaktelektroden (7a-7d; 17a-17d) maximal 20% der Seitenlänge des aktiven Bereichs (5) beträgt.

2. Hall-Sensorelement (1) nach Anspruch 1, bei dem der aktive Bereich (5) rechteckig ausgebildet ist und bei dem die Kontaktelektroden (7a-7d) in den diagonal gegenüberliegenden Ecken des aktiven Bereichs (5) angeordnet sind.

3. Hall-Sensorelement (1) nach Anspruch 1 oder 2, bei dem der kreissegmentförmige, elliptische, parabelförmige oder hyperbelförmige Verlauf des dem aktiven Bereich (5) zugewandten Abschnitts der Kontaktelektroden (7a-7d) zum aktiven Bereich (5) hin gewölbt ist.

4. Hall-Sensorelement (1) nach einem der Ansprüche 1 bis 3, bei dem an den jeweiligen trapezförmigen Kontaktelektroden (7a-7d) in der kürzeren, dem aktiven Bereich zugewandten Grundlinie des Trapez ein kreissegmentförmiger, elliptischer, parabelförmiger oder hyperbelförmiger Verlauf vorgesehen ist.

5. Hall-Sensorelement (1) nach Anspruch 1, bei dem der aktive Bereich (5) die Form eines regelmäßigen Vielecks aufweist.

6. Hall-Sensorelement (10) nach Anspruch 1, bei dem der aktive Bereich (15) kreuzförmig ausgebildet ist und die Kontaktelektroden (17a-17d) in jeweils gegenüberliegenden Kreuzarmen des aktiven Bereichs (15) angeordnet sind.

7. Hall-Sensorelement (10) nach Anspruch 1, bei dem der aktive Bereich (15) sternförmig ausgebildet ist und die Kontaktelektroden (17a-17d) in jeweils gegenüberliegenden Sternarmen des aktiven Bereichs (15) angeordnet sind.

8. Hall-Sensorelement (10) nach einem der Ansprüche 5 bis 7, bei dem der kreissegmentförmige, elliptische, parabelförmige oder hyperbelförmige Verlauf des dem aktiven Bereich (15) zugewandten Abschnitts der Kontaktelektroden (17a-17d) zum aktiven Bereich (15) hin gewölbt ist.

9. Hall-Sensorelement (10) nach einem der Ansprüche 5 bis 7, bei dem an den jeweiligen trapezförmigen Kontaktelektroden (17a-17d) in der kürzeren, dem aktiven Bereich zugewandten Grundlinie des Trapez ein kreissegmentförmiger, elliptischer, parabelförmiger oder hyperbelförmiger Verlauf vorgesehen ist.

## Claims

1. Hall sensor element (1; 10) comprising an active area (5; 15) and contact electrodes (7a - 7d; 17a - 17d), wherein said contact electrodes (7a - 7d; 17a - 17d) are formed by two opposite current supply contact electrodes (7a, 7c; 17a, 17c) between which said active area (5, 15) is defined for generating a current flow through said active area (5, 15) and by two opposite voltage tapping contact electrodes (7b, 7d; 17b, 17d) for tapping-off a hall voltage
**characterized in that**
a portion of said contact electrodes (7a - 7d; 17a - 17d) facing said active area and being adjacent to said active area (5, 15) has a geometry that is step-shaped, circular segment-shaped, elliptic, parabola-shaped, hyperbola-shaped or trapezoid-shaped or has a rectangular extension, in order to reduce the interfering influence of said contact electrodes (7a - 7d; 17a - 17d) on the offset-reducing effect of the spinning current operation, wherein all contact electrodes (7a - 7d; 17a - 17d) have an identical geometry and are symmetrically disposed referring to said active area (5; 15), respectively and wherein the side length of said contact electrodes (7a - 7d; 17a - 17d) is, at the most, 20% of the side length of said active area (5).

2. Hall sensor element (1) according to claim 1, wherein said active area (5) is rectangularly formed and wherein said contact electrodes (7a - 7d) are disposed in the diagonally opposite corners of said active area (5).

3. Hall sensor element (1) according to claim 1 or 2, wherein the circular segment-shaped, elliptic, parabola-shaped or hyperbola-shaped contour of the portion of said contact electrodes (7a - 7d) facing said active area (5) is curved towards said active area (5).

4. Hall sensor element (1) according to one of the claims 1 to 3, wherein, at the respective trapezoid-shaped contact electrodes (7a - 7d) in the shorter baseline of the trapezoid facing said active area, a circular segment-shaped, elliptic, parabola-shaped or hyperbola-shaped contour is provided.

5. Hall sensor element (1) according to claim 1, wherein said active area (5) has the shape of a regular polygon.

6. Hall sensor element (10) according to claim 1, wherein said active area (15) is formed cross-shaped and said contact electrodes (17a - 17d) are disposed in respectively opposite cross-arms of said active area (15).

7. Hall sensor element (10) according to claim 1, wherein said active area (15) is formed star-shaped and said contact electrodes (17a - 17d) are disposed in respectively opposite star-arms of said active area (15).

8. Hall sensor element (10) according to one of the claims 5 to 7, wherein the circular segment-shaped, elliptic, parabola-shaped or hyperbola-shaped contour of the portion of said contact electrodes (17a - 17d) facing said active area (15) is curved towards said active area (15).

9. Hall sensor element (10) according to one of the claims 5 to 7, wherein at said respective trapezoid-shaped contact electrodes (17a - 17d) in the shorter baseline of the trapezoid facing said active area, a circular segment-shaped, elliptic, parabola-shaped or hyperbola-shaped contour is provided.

## Revendications

1. Element capteur de Hall (1 ; 10) avec une zone active (5 ; 15) et des électrodes de contact (7a à 7d ; 17a à 17d), les électrodes de contact (7a à 7d ; 17a à 17d) étant formées par deux électrodes de contact d'alimentation de courant 7a, 7c ; 17a, 17c) opposées, entre lesquelles est définie la zone active (5 ; 15), destinées à générer un flux de courant dans la zone active (5 ; 15), et de deux électrodes de contact de prélèvement de tension (7b, 7d ; 17b, 17d) opposées destinées à prélever une tension de Hall, **caractérisé par le fait qu'**un segment des électrodes de contact (7a à 7d ; 17a à 17d), orienté vers la zone active (5 ; 15) et adjacent à la zone active (5 ; 15), présente une géométrie qui est à paliers, en forme de segment de cercle, elliptique, parabolique, hyprbolique ou trapézoïdale ou qui présente une élévation carrée, afin de réduire l'influence des électrodes de contact (7a à 7d ; 17a à 17d) sur l'action de réduction de décalage du fonctionnement à courant rotatif, toutes les électrodes de contact (7a à 7d ; 17a à 17d) présentant une même géométrie et étant disposées, chacune, de manière symétrique par rapport à la zone active (5 ; 15) et la longueur de côté des électrodes de contact (7a à 7d ; 17a à 17d) étant de tout au plus 20% de la longueur de côté de la zone active (5).

2. Element capteur de Hall (1) selon la revendication 1, dans lequel la zone active (5) se présente rectangulaire et dans lequel les électrodes de contact (7a à 7d) sont disposées dans les coins diagonalement opposés de la zone active (5).

3. Element capteur de Hall (1) selon la revendication 1 ou 2, dans lequel l'évolution en segment de cercle, elliptique, parabolique ou hyperbolique du segment, orienté vers la zone active (5), des électrodes de contact (7a à 7d) est bombée vers la zone active (5).

4. Element capteur de Hall (1) selon l'une des revendications 1 à 3, dans lequel est prévue aux électrodes de contact (7a à 7d) trapézoïdales respectives, sur la ligne de base courte orientée vers la zone active, une évolution en segment de cercle, elliptique, parabolique ou hyperbolique.

5. Element capteur de Hall (1) selon la revendication 1, dans lequel la zone active (5) présente la forme d'un polygone régulier.

6. Element capteur de Hall (10) selon la revendication 1, dans lequel la zone active (15) se présente en forme de croix et les électrodes de contact (17a à 17d) sont disposées dans chacun des bras opposés de la croix de la zone active (15).

7. Element capteur de Hall (10) selon la revendication 1, dans lequel la zone active (15) se présente en forme d'étoile et les électrodes de contact (17a à 17d) sont disposées dans chacun des bras opposés de l'étoile de la zone active (15).

8. Element capteur de Hall (10) selon l'une des revendications 5 à 7, dans lequel l'évolution en segment de cercle, elliptique, parabolique ou hyperbolique du segment, orienté vers la zone active (15), des électrodes de contact (17a à 17d) est bombée vers la zone active (15).

9. Element capteur de Hall (10) selon l'une des revendications 5 à 7, dans lequel est prévue aux électrodes de contact (17a à 17d) trapézoïdales respectives, sur la ligne de base courte orientée vers la zone active, une évolution en segment de cercle, elliptique, parabolique ou hyperbolique.
